Europäisches Patentamt

European Patent Office

Office européen des brevets

(19)

(11) Veröffentlichungsnummer : **0 026 838**
**B1**

(12) # EUROPÄISCHE PATENTSCHRIFT

(45) Veröffentlichungstag der Patentschrift :
03.08.83

(21) Anmeldenummer : 80105123.6

(22) Anmeldetag : 28.08.80

(51) Int. Cl.³ : **H 05 K   9/00, H 04 B 15/02, H 02 M   1/12**

(54) **Anordnung zur Funkentstörung von Schaltnetzteilen.**

(30) Priorität : 17.09.79 DE 2937539

(43) Veröffentlichungstag der Anmeldung :
15.04.81 Patentblatt 81/15

(45) Bekanntmachung des Hinweises auf die Patenterteilung : 03.08.83 Patentblatt 83/31

(84) Benannte Vertragsstaaten :
**BE FR GB IT NL SE**

(56) Entgegenhaltungen :
**DD A 131 516**
**DE A 2 264 112**
**DE A 2 608 542**
**DE B 2 446 624**

(73) Patentinhaber : **SIEMENS AKTIENGESELLSCHAFT**
**Berlin und München Wittelsbacherplatz 2**
**D-8000 München 2 (DE)**

(72) Erfinder : **Schierjott, Rudolf, Ing. grad.**
**Blumenstrasse 3**
**D-8034 Germering (DE)**

## Anordnung zur Funkentstörung von Schaltnetzteilen

Die Erfindung betrifft eine Anordnung zur Funkentstörung gemäß dem Oberbegriff des Anspruches 1.

Elektronische Schaltungen mit als Schalter arbeitenden Halbleitern stellen oft Hochfrequenzstörquellen mit ausgedehntem Frequenzspektrum dar. Um Funkstörungen zu vermeiden, müssen die Hochfrequenzspannungen auf den Ein- und Ausgangsleitungen solcher Geräte durch besondere Maßnahmen unterdrückt werden.

Die Funkentstörung von netzgespeisten elektronischen Geräten der eingangs genannten Art bereitet unter Umständen sehr große Schwierigkeiten, wenn unter Beachtung besonderer Vorschriften für die Schutzisolierung der Geräte deren Bezugspotential an keinen Schutzleiter angeschlossen werden darf. Die Maßnahmen für eine ausreichende Funkentstörung werden dadurch weiter erschwert, daß elektronische Schaltungen ohne galvanische Trennung am Netz betrieben werden. Die Verwendung von Siebschaltungen mit großen Kapazitäten im Stromkreis der Netzleitungen kann eine ausreichende Unterdrückung der Funkstörspannung nicht sicherstellen, da hochfrequente Störspannungen über Wicklungskapazitäten des Übertragers und andere Schaltungskapazitäten unvermeidlich unsymmetrisch von Netzleitungen fortgeleitet werden.

Es ist aus der DE-B-24 46 624 bekannt, den netzeingangsseitigen und den ausgangsseitigen Schaltungsteil der zu entstörenden Schaltung vollständig mit einer Abschirmung zu versehen. Eine derartige Abschirmung hat jedoch den Nachteil, daß bei hohen Frequenzen die Schirme zu hohe induktive Widerstände aufweisen und damit eine Ableitung der hochfrequenten Ströme verhindern.

Aus der DD-A-13 15 16 ist es bekannt, zur Funkentstörung eine beidseitig mit einer leitenden Folie überzogene Isolierplatte die als Kondensator wirkt, zu verwenden, wobei jede Folie mit verschiedenen Massepunkten verbunden ist.

Der Erfindung liegt die Aufgabe zugrunde, die von Schaltungen der eingangs genannten Art erzeugten, bis in den Megahertz-Bereich reichenden Hochfrequenz-Störspannungen auf zulässig kleine Werte zu reduzieren.

Diese Aufgabe wird gemäß der Erfindung bei einer Schaltung der eingangs genannten Art dadurch gelöst, daß zwischen dem geschirmten netzseitigen und dem geschirmten ausgangsseitigen Schaltungsteil der zu entstörenden Schaltung eine großflächige, an beiden Oberflächen mit ganzflächigen Elektroden versehene Leiterplatte angeordnet ist, deren eine Elektrode mit dem netzseitigen Schirm und deren andere Elektrode mit der dem ausgangsseitigen Schirm zugeordneten breiten Masse in Verbindung steht.

Bei einer vorteilhaften Ausführungsform der Anordnung ist der netzseitige und der ausgangsseitige Schaltungsteil jeweils auf zwei getrennten Leiterplatten angeordnet, zwischen denen die großflächig doppelkaschiert ausgebildete Leiterplatte angeordnet ist.

Durch die Anordnung der erfindungsgemäßen doppelkaschierten Leiterplatte zwischen dem eingangsseitigen und dem ausgangsseitigen Schaltungsteil wird trotz des geforderten Verzichtes auf die die netzspannungsführenden Teile der Schaltungsanordnung gegen Masse koppelnden Kondensatoren eine ausreichende Entstörung im hochfrequenten Bereich erzielt. Gleichzeitig kann eine derartige Leiterplatte noch zusätzliche Schirmzwecke zwischen den beiden Schaltungsteilen erfüllen. Außerdem dient sie bei der räumlich engen Montage zur Abstandhaltung.

Durch Freiätzen der Plattenränder der Leiterplatte ist es möglich, die entsprechend den Schutzvorschriften erforderlichen Kriech- und Luftstrecken in einfacher Weise zu erzeugen.

Eine Ausführungsform der Erfindung ist in den Zeichnungen dargestellt und wird im folgenden beispielsweise näher beschrieben.

Es zeigen

Figur 1 eine schematische Darstellung eines Funkentstör-Ersatzschaltbildes einer geschirmten Schaltstromversorgung mit der erfindungsgemäßen Leiterplatte und

Figur 2 eine schematische Darstellung einer Ausführung der Leiterplatte in einem Schaltnetzteil.

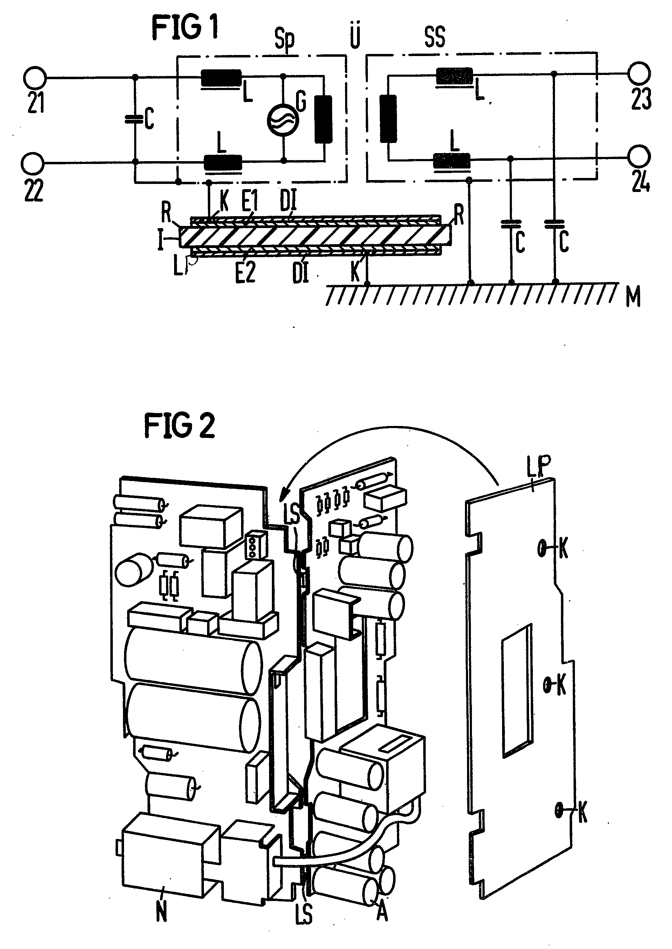

Die Fig. 1 ist eine zu entstörende Schaltung mit einem Hochfrequenzstörgenerator G dargestellt, deren netzseitiger Teil mit dem Eingang 21, 22 durch einen Übertrager Ü vom Ausgang 23, 24 galvanisch getrennt ist. Zwischen dem Störgenerator G und den Eingangsklemmen sowie zwischen der Sekundärwicklung des Übertragers Ü und den Ausgangsklemmen ist je eine LC-Siebschaltung eingeschaltet.

Während der netzseitige Schaltungsteil mit der Primärwicklung des Übertragers voraussetzungsgemäß nicht mit dem Netzschutzleiter verbunden sein darf, ist der ausgangsseitige Teil der Schaltung an ein Bezugspotential M gelegt. Dieses Bezugspotential M kann z. B. die Gerätemasse (Gehäuse) sein. Der netzseitige und der ausgangsseitige hochfrequente Störspannungen abgebende Teil der Schaltung sind durch Schirme SP und SS umschlossen. In die Schirme werden damit zwangsläufig Störspannungen eingeprägt, die im Netzkreis wirksam werden können. Bei hohen Störfrequenzen weisen derartige Schirme jedoch hohe induktive Widerstände auf, die eine Ableitung der Störungen verhindern. Dies wird jedoch durch die erfindungsgemäße Leiterplatte bewerkstelligt. Die Leiterplatte LP ist eine doppelt kaschierte Leiterplatte, die aus einer tragenden Isolationsschicht I besteht, auf der beidseitig großflächige isolierte Elektroden E1 und E2 angeordnet sind. Die Elektrode E1 steht dabei mit dem Primärschirm SP und die Elektrode E2 mit der Gerätemasse M und damit mit dem Sekundärschirm SS in Verbindung. Die Deckisolationsschichten DI der Leiterplatte LP sind an den Kontaktstellen K unterbrochen. Zur Erzeugung der gemäß den Vorschriften erforderlichen Kriech- und Luftstrecken sind an den Rändern R der Leiterplatte LP die Elektroden E1 und E2 weggeätzt.

Bei der in der Fig. 2 dargestellten Ausführung des Schaltnetzteiles sind der netzseitige N und der ausgangsseitige A Schaltungsteil auf zwei getrennten Leiterplatten angeordnet. Diese Leiterplatten N und A stehen über Isolationslaschen LS miteinander in Verbindung und können voneinander weggeschwenkt werden. Zwischen die beiden Leiterplatten N und A wird die entsprechend ausgebildete Leiterplatte LP eingelegt, der eingangsseitige Primärschirm SP und der ausgangsseitige Sekundärschirm SS sind dabei aus Gründen der Übersichtlichkeit nicht dargestellt.

Bei einer derartigen Anordnung bedämpft die Leiterplatte nicht nur die hochfrequenten Störungen, sondern sie erfüllt zusätzliche Schirmzwecke. Auch dient sie zusätzlich noch als Abstandhalter, um beim Einbau der Leiterplatten N und A ein Berühren der Bauelemente untereinander zu verhindern.

Bezugszeichenliste

G Störquelle
Ü Transformator des Schaltnetzteiles
DJ Deckisolationsschichten
C Entstörkondensatoren
L Entstördrosseln
SP Primärschirm
SS Sekundärschirm
M Gerätemasse (z. B. Gehäuse)
LP Leiterplatte
R Ätzrand
E1, E2 Elektroden
J Isolater
21, 22 Eingang
23, 24 Ausgang
K Kontaktstelle
N eingangsseitiger Teil des Schaltnetzteiles
A Ausgangsseitiger Teil des Schaltnetzteiles
LS Lasche
V Ausnehmung

Ansprüche

1. Anordnung zur Funkentstörung von hochfrequente Störspannungen erzeugenden elektronischen Geräten mit durch Übertrager (Ü) galvanisch getrenntem, geschirmtem Ein- (21, 22) und Ausgang (23, 24) unter Verwendung von eingangs- und ausgangsseitig angeordneten Siebschaltungen, wobei der ausgangsseitige Schirm (SS) mit einer Gerätemasse (M) verbunden ist, dadurch gekennzeichnet, daß zwischen dem geschirmten netzseitigen (N) und dem geschirmten ausgangsseitigen (A) Schaltungsteil der zu entstörenden Schaltung eine großflächige, an beiden Oberflächen mit ganzflächigen Elektroden (E1, E2) versehene Leiterplatte (LP) angeordnet ist, deren eine Elektrode (E1) mit dem netzseitigen Schirm (SP) und deren andere Elektrode (E2) mit der dem ausgangsseitigen Schirm (SS) zugeordneten Gerätemasse (M) in Verbindung steht.

2. Anordnung nach Anspruch 2, dadurch gekennzeichnet, daß der netzseitige und der ausgangsseitige Schaltungsteil auf zwei getrennten Leiterplatten (N, A) angeordnet sind, zwischen denen die großflächig doppelkaschiert ausgebildete Leiterplatte (LP) angeordnet ist.

3. Anordnung nach einem der Ansprüche 1 oder 2, dadurch gekennzeichnet, daß die Ränder (R) der Leiterplatte (LP) freigeätzt sind.

Claims

1. An arrangement for radio interference suppression of electronic apparatus which produces high-frequency interference voltages, comprising a screened input (21, 22) and output (23, 24) which are d. c. isolated by transformers (Ü), employing filter circuits arranged at the input and output ends, the screen (SS) at the output end being connected to an apparatus earth (M), characterised in that between the screened circuit component at the mains side (N) and the screened circuit component at the output side (A) of the circuit whose interference is to be suppressed, there is arranged a printed circuit board (LP) which has a large area on both surfaces covered by electrodes (E1, E2) and the electrode (E1) on one side of the printed circuit board is connected to the screen (SP) at the mains side and the other electrode (E2) is connected to the apparatus earth (M) which is connected to the screen at the output side.

2. An arrangement as claimed in Claim 2, characterised in that the circuit component at the mains side and that at the output side are arranged on two separate printed circuit boards (N, A) between which is arranged the printed circuit board (LP) having a double lining over the large area.

3. An arrangement as claimed in one of Claims 1 or 2, characterised in that the edges (R) of the printed circuit board (LP) are etched free.

Revendications

1. Dispositif pour l'antiparasitage d'appareils électroniques produisant des tensions parasites haute fréquence, avec une entrée (21, 22) et une sortie (23, 24) blindées et séparées galvaniquement à l'aide d'un transformateur (Ü), et mise en œuvre de circuits filtrants disposés du côté entrée et du côté sortie, le blindage (SS) situé du côté sortie étant relié à une masse (M) de l'appareil, caractérisé par le fait qu'entre la partie du circuit blindée du circuit à antiparasiter et située du côté réseau (N) et la partie du circuit blindée du circuit à antiparasiter et située du côté sortie (A), est disposée une plaque conductrice (LP) de grande surface, pourvue sur ses deux surfaces d'électrodes pleine surface (E1, E2), dont une électrode (E1) est en liaison avec le blindage (SP) situé du côté réseau, et dont l'autre électrode (E2) est en liaison avec la masse (M) de l'appareil associée au blindage (SS) situé du côté sortie.

2. Dispositif selon la revendication 1, caractérisé par le fait que la partie de circuit située du côté réseau et la partie du circuit située du côté sortie sont disposées sur deux plaquettes imprimées distinctes (N, A) entre lesquelles est disposée la plaque conductrice de grande surface (LP) réalisée avec un double revêtement.

3. Dispositif selon l'une des revendications 1 ou 2, caractérisé par le fait que les bords (R) de la plaque conductrice (LP) sont dénudés par attaque chimique.

**FIG 1**

**FIG 2**